# EUROPEAN PATENT SPECIFICATION

(11) **EP 4 391 580 B1**
(45) Date of publication and mention of the grant of the patent: **07.10.2026**
(21) Application number: 23172797.5
(22) Date of filing: 11.05.2023
(51) Int. Cl.: H04R 1/06, H05K 9/00, H04R 1/1025

(54) **SPEAKER ASSEMBLY, MAGNETIC FIELD COUNTERACTING METHOD, AND ELECTRONIC DEVICE**
LAUTSPRECHERANORDNUNG, MAGNETFELD-GEGENMASSNAHMEVERFAHREN UND ELEKTRONISCHE VORRICHTUNG
ENSEMBLE HAUT-PARLEUR, PROCÉDÉ DE NEUTRALISATION DE CHAMP MAGNÉTIQUE ET DISPOSITIF ÉLECTRONIQUE

(30) Priority: 21.12.2022 CN 202211652219
(43) Date of publication of application: 26.06.2024
(73) Proprietor: Beijing Xiaomi Mobile Software Co., Ltd., Beijing 100085 (CN)
(72) Inventor: YUE, Xiaolong, Beijing, 100085 (CN); ZHANG, Min, Beijing, 100085 (CN)
(74) Representative: Stöckeler, Ferdinand

(56) References cited:
- CN-U- 217 215 005
- CN-U- 217 691 453
- CN-U- 217 933 902

## Description

### TECHNICAL FIELD

This application relates to a field of electronic technology, and more particularly, a speaker assembly, a magnetic field counteracting method, and an electronic device.

### BACKGROUND

Speakers are used in electronic devices such as mobile phones and earphones. Speakers are prone to electromagnetic interference generated by internal components of the devices during operation, which results in noise and poor speaker performance. The interference problem becomes serious as the sensitivity of speakers increases, degrading user experience.

CN 217 215 005 U relates to a circuit structure, a battery and electronic equipment. The circuit structure comprises a battery cell and a conductive structure, the battery cell comprises a positive plate and a negative plate, the positive plate and the negative plate are wound, and the part, crossing the outer side end of the positive plate, of the outer side end of the negative plate is an extension section in the winding direction of the negative plate; the conductive structure comprises a first end part and a second end part, at least one end is connected with the positive plate or the negative plate, and the conductive structure is configured to weaken an electromagnetic field generated by the conductive structure and an electromagnetic field generated by the extension section. Therefore, at least one end of the first end part and the second end part of the conductive structure is connected with the positive plate or the negative plate, and the conductive structure is configured to weaken an electromagnetic field generated by the epitaxial section; therefore, the conductive structure generates a magnetic field opposite to the battery cell to form magnetic field offset and can fully offset magnetic field radiation generated by the extension section to the outside.

CN 217 933 902 U relates to a winding type battery, which comprises a shell, a winding core and a conductive piece, the winding core comprises a first pole piece and a second pole piece which are stacked and then wound into a column shape, the telecentric end of the first pole piece is provided with a first pole lug, and the telecentric end of the second pole piece crosses the telecentric end of the first pole piece and is provided with a second pole lug. The winding core is arranged in the shell, the part, wound by more than one part, of the telecentric end relative to the telecentric end of the first pole piece, of the telecentric end of the second pole piece is an extending section, the conductive piece is attached to the outer side face or the upper end face or the lower end face of the shell and located at the position corresponding to the extending section, and one end of the conductive piece is electrically connected with the second pole lug. The current flowing through the conductive part and the current flowing through the extension section are equal in magnitude and opposite in direction. The first tab and the second tab are arranged in a staggered mode, short circuit of the first tab and the second tab is avoided, the conductive piece corresponding to the extending section is attached to the side face of the shell, and noise generated by the loudspeaker due to electromagnetic interference is eliminated.

CN 217 691 453 U relates to a winding structure for a battery, the battery and an earphone with the battery. The winding structure comprises a positive plate and a negative plate. The positive plate is wound along a first direction relative to the winding axis of the winding structure and is electrically connected with a positive tab; the negative plate and the positive plate are stacked and are wound along the first direction relative to the winding axis, and the end part of the negative plate is electrically connected with a negative tab. The negative plate is longer than the positive plate. The negative plate comprises a reverse winding section, and the reverse winding section is wound along a second direction opposite to the first direction, so that the end part, positioned on the outer side of the winding structure, of the positive plate and the end part, positioned on the outer side of the winding structure, of the negative plate are aligned in the radial direction about the winding axis. Therefore, leakage of a winding structure of a traditional battery to an external magnetic field can be avoided.

### SUMMARY

The present invention provides a speaker assembly according to claim 1, an earphone according to claim 9, and a magnetic field counteracting method according to claim 10, to solve the problems in the related art.

The present invention is defined in independent claims, and the preferable features according to the present invention are defined in the dependent claims. Any embodiment in the present disclosure that does not fall within the scope of the present invention should be regarded as an example for understanding the present invention.

A first aspect of the present invention provides a speaker assembly. The speaker assembly includes: a battery including a core, a positive electrode tab, and a negative electrode tab, the positive electrode tab and the negative electrode tab being electrically connected to the core and being arranged on a first end face of the core; an audio component including a second end face facing the first end face; and a magnetic field counteracting component arranged on the second end face and including a conductor and an insulating layer between the conductor and the second end face. A counteracting current into the conductor forms a counteracting magnetic field acting on the audio component, and the counteracting magnetic field counteracts an interfering magnetic field acting by the battery on the audio component.

Optionally, the conductor includes a first end and a second end; and in a thickness direction of the battery, the first end corresponds to a position of the positive electrode tab and the second end corresponds to a position of the negative electrode tab.

Optionally, the core forms a main interference section between the positive electrode tab and the negative electrode tab, and a projection of the conductor in the thickness direction of the battery coincides with the main interference section.

Optionally, an included angle between the positive electrode tab and the negative electrode tab includes 90°, and the conductor includes a 1/4 circular ring assembled on the insulating layer; or an included angle between the positive electrode tab and the negative electrode tab is 180°, and the conductor includes a 1/2 circular ring assembled on the insulating layer.

Optionally, the conductor is in an edge region of the second end face.

Optionally, the conductor includes a flexible circuit board or a wire assembled on the insulating layer.

Optionally, the battery includes a soft-packed battery, and the positive electrode tab and the negative electrode tab are exposed outside the core, or the battery includes a hard-packed battery, and the positive electrode tab and the negative electrode tab are arranged inside the core; and, in a thickness direction of the battery, at least a portion of the conductor corresponds to positions of the positive electrode tab and the negative electrode tab.

Optionally, the conductor is connected in series with the battery, to obtain the counteracting current that is equal in magnitude and opposite in direction to the system current of the battery.

The insulating layer covers the second end face. Optionally, the insulating layer includes a packaging structural member on the audio component. The insulating layer includes an insulating adhesive layer bonded to the audio component.

A second aspect of the present invention provides an earphone including the speaker assembly according to the first aspect.

A third aspect of the present invention provides a magnetic field counteracting method applied to the speaker assembly according to the first aspect. The magnetic field counteracting method includes: determining an assembly region of the conductor based on positions of the positive electrode tab and the negative electrode tab; and arranging the magnetic field counteracting component on the second end face, fixing the conductor in the assembly region, and arranging the insulating layer between the conductor and the second end face.

Optionally, determining the assembly region of the conductor based on the positions of the positive electrode tab and the negative electrode tab includes: determining formation of a main interference section between the positive electrode tab and the negative electrode tab of the core; and determining the assembly region based on a projection of the main interference section in the thickness direction of the battery.

Optionally, the magnetic field counteracting method further includes: adjusting an intensity of the counteracting magnetic field based on an intensity of a magnetic field of the battery in a working state that at least includes an audio playback state and a call state.

Optionally, arranging the magnetic field counteracting component on the second end face, fixing the conductor in the assembly region, and arranging the insulating layer between the conductor and the second end face includes: arranging the insulating layer on the second end face; and determining the assembly region on the insulating layer, and fixing the conductor in the assembly region.

Optionally, the magnetic field counteracting method further includes: electrically connecting a first end of the conductor to the positive electrode tab, and electrically connecting a second end of the conductor to the negative electrode tab.

The technical solutions of the present invention can achieve at least the following beneficial effects. Since the speaker assembly includes the magnetic field counteracting component, and the magnetic field counteracting component is arranged on the end face of the audio component facing the battery with the electrode tabs, when the counteracting current into the conductor forms the counteracting magnetic field acting on the audio component, the counteracting magnetic field and the interfering magnetic field applied by the battery to the audio component can cancel each other out. The above solution is directed at counteraction of the interfering magnetic field acting on the audio component, has low cost, high accuracy, and few structural changes, and improves the sound effect of the speaker assembly and the earphone using the speaker assembly.

It should be understood that the above general description and the detailed description below are only illustrative and explanatory and do not limit the present invention.

### BRIEF DESCRIPTION OF DRAWINGS

In order to more clearly explain technical solutions in embodiments of the present invention, the drawings useful in the description of the embodiments will be briefly introduced. Obviously, the drawings in the following description illustrate only some embodiments of the present invention. For those skilled in the art, other drawings can be obtained from these drawings without any creative effort.
FIG. 1 is an exploded view of a speaker assembly according to an embodiment of the present invention.
FIG. 2 is a schematic view of an audio component of the speaker assembly of FIG. 1, according to an embodiment of the present invention.
FIG. 3 is a schematic view of an earphone according to an embodiment of the present invention.
FIG. 4 is a flowchart of a magnetic field counteracting method according to an embodiment of the present invention.

### DETAILED DESCRIPTION

Embodiments of the present invention will be described in detail below, and examples of the described embodiments are shown in the drawings. When the following description refers to the drawings, unless otherwise indicated, the same or similar elements are denoted by like reference numerals throughout the drawings. The implementations described in the following embodiments do not represent all possible embodiments consistent with the present invention. Instead, they are only examples of devices and methods consistent with some aspects of the present invention.

Terms used in the present description are only for the purpose of describing specific embodiments, and are not intended to limit the present invention. Unless otherwise defined, technical or scientific terms in the present application should have usual meaning understood by a person with ordinary skills in the field to which the present invention belongs. Terms such as "first" and "second" are used herein are not intended to indicate any sequence, quantity or importance, but are only used to distinguish different elements. Similarly, words such as "an" or "a" do not indicate a quantitative restriction, but rather indicate the existence of at least one. If only "one" is referred to, it will be indicated specifically. "A plurality of" or "several" means two or more. Unless otherwise indicated, terms "front," "rear," "lower," and/or "upper," "top," "bottom," and the like are for illustrative purposes only, and are not limited to a particular location or spatial orientation. Terms such as "including" or "comprising" mean that elements or objects appearing before "including" or "comprising" contains elements or objects listed after "including" or "comprising" and their equivalents, and do not exclude other elements or objects. Terms such as "coupled" or "connected" are not limited to physical or mechanical connections, and may include electrical connections, regardless of direct or indirect connections.

Speakers are used in electronic devices such as mobile phones and earphones. Speakers are prone to electromagnetic interference generated by internal components of the devices during operation, and result in noise. The interference problem becomes serious as the sensitivity of speakers increases, degrading user experience. In the related art, shielding schemes directed at interference sources are often adopted, but the schemes are not only costly, but also difficult to achieve overall coverage of the interference sources, and hence fail to weaken an electromagnetic field across the entire space. Consequently, speakers are still subjected to electromagnetic interference during operation.

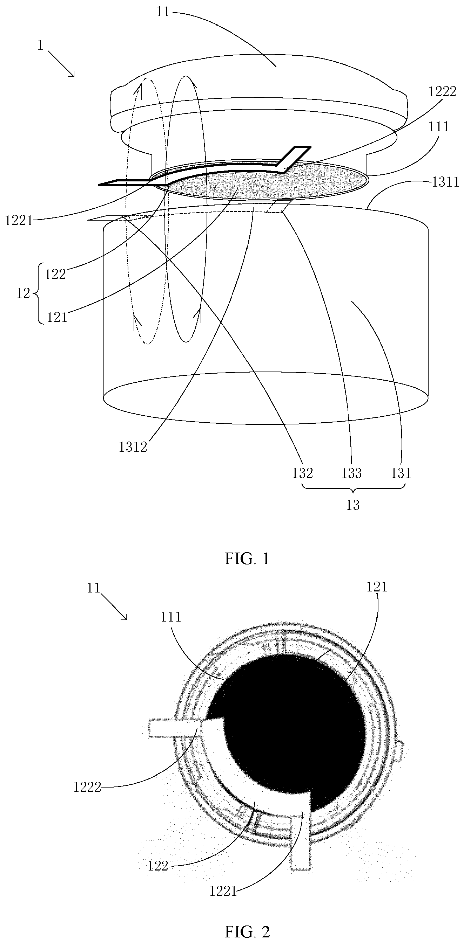

The present invention provides a speaker assembly. FIG. 1 is an exploded view of a speaker assembly according to an embodiment of the present invention. As shown in FIG. 1, a dotted arrow represents a direction of a magnetic field generated by a conductor 122, and a dash-dotted arrow represents a direction of a magnetic field generated by system current of a battery 13. The speaker assembly 1 includes a battery 13, an audio component 11, and a magnetic field counteracting component 12. The battery 13 includes a core 131, a positive electrode tab 132, and a negative electrode tab 133. The positive electrode tab 132 and the negative electrode tab 133 are electrically connected to the core 131 and are arranged on a first end face 1311 of the core 131. The audio component 11 includes a second end face 111 facing the first end face 1311. The magnetic field counteracting component 12 is arranged on the second end face 111. The magnetic field counteracting component 12 includes the conductor 122, and an insulating layer 121 between the conductor 122 and the second end face 111. A counteracting current into the conductor 122 forms a counteracting magnetic field acting on the audio component 11, and the counteracting magnetic field counteracts an interfering magnetic field acting by the battery 13 on the audio component 11.

Since the speaker assembly 1 includes the magnetic field counteracting component 12, and the magnetic field counteracting component 12 is arranged on the end face of the audio component 11 facing the battery 13 with the electrode tabs, when the counteracting current into the conductor 122 forms the counteracting magnetic field acting on the audio component 11, the counteracting magnetic field and the interfering magnetic field applied by the battery 13 to the audio component 11 can cancel each other out. The above solution is directed at counteraction of the interfering magnetic field acting on the audio component 11, has low cost, high accuracy, and few structural changes, and improves the sensitivity and sound effect of the speaker assembly 1. In addition, the arrangement of the magnetic field counteracting component 12 on the audio component 11 can make the conductor 122 close to coils of the audio component 11, improving the counteraction accuracy and counteraction effect. Since the interfering magnetic field acting on the audio component 11 is cancelled out, the speaker assembly 1 can be used as a high-sensitivity speaker.

The above solution can reduce a current sound by 8 dB, significantly improve the sound production effect, expand an effective low-radiation area by more than 5 times, and have a cost benefit of about 50%.

It should be noted that the battery 13 may be a soft-packed battery or a hard-packed battery, which is not limited in the present invention. When the battery is a soft-packed battery, the positive electrode tab 132 and the negative electrode tab 133 are exposed outside the core 131. The positive electrode tab 132 and the negative electrode tab 133 exposed outside the core 131 can facilitate position identification, determining a position of a main interfering magnetic field acting on the audio component 11, helping to improve the accuracy and convenience of the arrangement of the magnetic field counteracting component 12. When the battery 13 is a hard-packed battery, the positive electrode tab 132 and the negative electrode tab 133 are arranged inside the core 131. Positions of the positive electrode tab 132 and the negative electrode tab 133 can be determined by X-rays, determining the position of the main interfering magnetic field, and improving the accuracy of the arrangement of the magnetic field counteracting component 12. In a thickness direction of the battery 13, at least a portion of the conductor 122 corresponds to the positions of the positive electrode tab 132 and the negative electrode tab 133.

In embodiments of the present invention, by providing the conductor 122 for the speaker assembly 1 and defining the arrangement position of the conductor 122, the counteracting magnetic field generated by the conductor 122 and the interfering magnetic field can cancel each other out. The arrangement position, material, and assembly method of the conductor 122 is explained by way of example.

In some embodiments, the conductor 122 includes a first end 1221 and a second end 1222. In the thickness direction of the battery 13, the first end 1221 corresponds to the position of the positive electrode tab 132, and the second end 1222 corresponds to the position of the negative electrode tab 133. By defining positions of the two ends of the conductor 122, a region where the conductor 122 generates a magnetic field can be basically determined, and the magnetic field acting on audio component 11 and the interfering magnetic field can cancel each other out.

In the above embodiments, the core 131 forms a main interference section 1312 between the positive electrode tab 132 and the negative electrode tab 133, and a projection of the conductor 122 in the thickness direction of the battery 13 coincides with the main interference section 1312. By defining the position of the conductor 122 as a whole, it can be determined that the region where the conductor 122 generates the magnetic field basically coincides with a region where the interfering magnetic field is generated. At this time, by making the counteracting current equal in magnitude and opposite in direction to the system current, the interfering magnetic field acting on the audio component 11 can be counteracted.

The first end 1221 and the second end 1222 can be bent relative to the conductor 122 and the core at a position corresponding to the main interference section 1312, and can extend towards the core away from the conductor 122 after bending, to facilitate access to the current.

In other embodiments, a projection of a structure of the conductor 122 between the first end 1221 and the second end 1222 in the thickness direction of the battery 13 slightly deviates from the position of the main interference section 1312 of the battery 13. The deviation caused by the above structural shape and position has no influence on the counteracting magnetic field acting on the audio component 11 and does not need to be considered; and if there is any influence, it can also be adjusted by the magnitude of the counteracting current.

In the above embodiments, the conductor 122 can be connected in series with the battery 13, to obtain the counteracting current that is equal in magnitude and opposite in direction to the system current of the battery 13. The way in which the conductor 122 is connected in series with the battery 13 can simplify the structure and control scheme of the speaker assembly 1. When the speaker assembly 1 is working, the conductor 122 can obtain the counteracting current equal in magnitude and opposite in direction to the system current.

In other embodiments, the counteracting current into the conductor 122 can also be controlled through a control mainboard of the speaker assembly 1. The control mainboard monitors the system current of the battery 13 and obtains the magnitude of the counteracting current through calculation, and the counteracting current is input into the conductor 122.

In the above embodiments, an included angle between the positive electrode tab 132 and the negative electrode tab 133 includes 90°, and the conductor 122 includes a 1/4 circular ring assembled on the insulating layer 121. The 1/4 circular ring of the conductor 122 corresponds, in position, to the main interference section 1312, which is between the positive electrode tab 132 and the negative electrode tab 133 and generates a strong magnetic field, so that a more accurate counteraction effect can be obtained.

In other embodiments, the included angle between the positive electrode tab 132 and the negative electrode tab 133 is 180°, and the conductor 122 includes a 1/2 circular ring assembled on the insulating layer 121. The 1/2 circular ring of the conductor 122 corresponds, in position, to the main interference section 1312, which is between the positive electrode tab 132 and the negative electrode tab 133 and generates a strong magnetic field, so that a more accurate counteraction effect can be obtained.

In other embodiments, the included angle between the positive electrode tab 132 and the negative electrode tab 133 can also be any other angle, which is not limited in the present invention. The length and position of the conductor 122 can be adjusted according to the included angle between the positive electrode tab 132 and the negative electrode tab 133. The present invention does not limit the specific length and shape of the conductor 122.

In some embodiments, as shown in FIGS. 1 and 2, the conductor 122 is in an edge region of the second end face 111, to reduce structural interference of the conductor 122 with the audio component 11 or other components of the speaker assembly 1, and improve the convenience of the structural assembly of the conductor 122. In other embodiments, the conductor 122 is located at any other location on the second end face 111, which is not limited in the present invention. For example, when a structural size of the audio component 11 is smaller than a structural size of the battery 13, the conductor 122 is at an edge position of the audio component 11 to be close to the positions of the electrode tabs, thereby generating the counteracting magnetic field that matches the interfering magnetic field. When the structural size of the audio component 11 is larger than the structural size of the battery 13, the conductor 122 is in the middle of the audio component 11 to be close to the positions of the electrode tabs, thereby generating the counteracting magnetic field that matches the interfering magnetic field.

In the above embodiments, the conductor 122 is a flexible circuit board or a wire assembled on the insulating layer 121. The conductor 122 has a flat structure when it is a flexible circuit board, and hence can reduce space occupation and improve assembly convenience.

The conductor 122 is fixed to the insulating layer 121 by adhesive bonding or is fixed to the insulating layer 121 by other means such as clamping.

The insulating layer 121 can avoid functional interference of the conductor 122 with the audio component 11. In some embodiments, the insulating layer 121 covers the second end face 111, increasing a working area of the insulating layer 121 to avoid the functional interference of the conductor 122 with the audio component 11.

In some embodiments, the insulating layer 121 is a packaging structural member on the audio component 11. The packaging structural member serves as a partial structure of the audio component 11, and there is no need to add the insulating layer 121 to the audio component 11. In other embodiments, the insulating layer 121 is an insulating adhesive layer bonded to the audio component 11. The insulating adhesive layer cannot only avoid the functional interference of the conductor 122 with the audio component 11, but also be fixed to the audio component 11 using its own adhesive function.

The insulating layer 121 is a double-sided adhesive that cannot only be bonded to the audio component 11, but also achieve the bonding and fixation of the conductor 122.

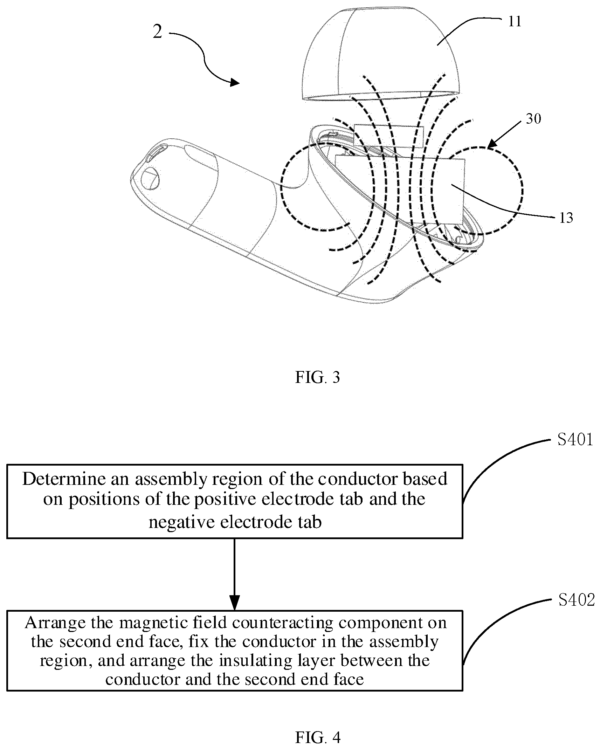

The present invention further provides an earphone 2. As shown in FIG. 3, the earphone 2 includes the speaker assembly 1 described above. A magnetic field 30 generated by the battery 13 of the speaker assembly 1 is shown in FIG. 3. The magnetic field counteracting component 12 on the audio component 11 can counteract the interfering magnetic field exerted by the battery 13 on the audio component 11 by using the counteracting magnetic field generated by the conductor 122.

Since the speaker assembly 1 includes the magnetic field counteracting component 12, and the magnetic field counteracting component 12 is on the end face of the audio component 11 facing the battery 13 with the electrode tabs, when the counteracting current into the conductor 122 forms the counteracting magnetic field acting on the audio component 11, the counteracting magnetic field and the interfering magnetic field acting by the battery 13 on the audio component 11 can cancel each other out. The above solution is directed at counteraction of the interfering magnetic field acting on the audio component 11, has low cost, high accuracy, and few structural changes, and improves the sound effect of the speaker assembly 1 and the earphone 2 using the speaker assembly 1.

It should be noted that the speaker assembly 1 may be applied to wearable devices such as mobile phones and smart watches, which will not be limited in the present invention.

The present invention further provides a magnetic field counteracting method applied to the speaker assembly 1 described above. FIG. 4 is a flowchart of a magnetic field counteracting method according to an embodiment of the present invention. As shown in FIG. 4, the magnetic field counteracting method can be realized through the following steps.

In step S401, an assembly region of the conductor 122 is determined based on the positions of the positive electrode tab 132 and the negative electrode tab 133.

In step S402, the magnetic field counteracting component 12 is arranged on the second end face 111, the conductor 122 is fixed in the assembly region, and the insulating layer 121 is arranged between the conductor 122 and the second end face 111.

Since the speaker assembly 1 includes the magnetic field counteracting component 12, and the magnetic field counteracting component 12 is on the end face of the audio component 11 facing the battery 13 with the electrode tabs, when the counteracting current into the conductor 122 forms the counteracting magnetic field acting on the audio component 11, the counteracting magnetic field and the interfering magnetic field acting by the battery 13 on the audio component 11 can cancel each other out. Since the above solution first determines the assembly region of the conductor 122 based on the positions of the positive electrode tab 132 and the negative electrode tab 133, the conductor 122 can directly counteract the interfering magnetic field acting on the audio component 11, with low cost, high accuracy, and few structural changes, improving the sound effect of the speaker assembly 1 and the earphone 2 using the speaker assembly 1.

In some embodiments, determining the assembly region of the conductor 122 based on the positions of the positive electrode tab 132 and the negative electrode tab 133 can include: determining formation of the main interference section 1312 between the positive electrode tab 132 and the negative electrode tab 133 of the core 131, and determining the assembly region based on a projection of the main interference section 1312 in the thickness direction of the battery 13. By defining the position of the conductor 122 as a whole, it can be determined that the region where the conductor 122 generates the magnetic field basically coincides with the region where the interfering magnetic field is generated. At this time, by making the counteracting current equal in magnitude and opposite in direction to the system current, the interfering magnetic field acting on the audio component 11 can be counteracted. The above method not only simplifies the structure of the speaker assembly 1, but also improves the control convenience.

In the above embodiments, an intensity of the counteracting magnetic field can be adjusted based on an intensity of the interfering magnetic field of the battery 13 in a working state, and the working state at least includes an audio playback state and a call state. Due to the difference in the intensity of the interfering magnetic field generated in the audio playback state and the call state, which acts on the audio component 11, the above solution can match the intensity of the interfering magnetic field with the working state of the battery 13. For example, the intensity of the interfering magnetic field generated in the audio playback state should be counteracted by the intensity of the counteracting magnetic field, which is expected to be equal in magnitude and opposite in direction, to avoid interference of the intensity of the counteracting magnetic field with a working stroke of the speaker.

In some embodiments, the magnetic field counteracting component 12 is arranged on the second end face 111, the conductor 122 is fixed in the assembly region, and the insulating layer 121 is between the conductor 122 and the second end face 111. This may include: arranging the insulating layer 121 on the second end face 111, determining the assembly region on the insulating layer 121, and fixing the conductor 122 in the assembly region. The insulating layer 121 is configured to avoid the functional interference of the conductor 122 with the audio component 11.

In some embodiments, the insulating layer 121 is a packaging structural member on the audio component 11. The packaging structural member serves as a partial structure of the audio component 11, and there is no need to add the insulating layer 121 to the audio component 11. In other embodiments, the insulating layer 121 is an insulating adhesive layer bonded to the audio component 11. The insulating adhesive layer cannot only avoid the functional interference of the conductor 122 with the audio component 11, but also be fixed to the audio component 11 using its own adhesive function.

In some embodiments, the magnetic field counteracting method also includes: electrically connecting a first end of the conductor 122 to the positive electrode tab 132, and electrically connecting a second end of the conductor 122 to the negative electrode tab 133.

The conductor 122 is connected in series with the battery 13, to obtain the counteracting current that is equal in magnitude and opposite in direction to the system current of the battery 13. In embodiments where it is necessary to input into the conductor 122 the counteracting current that is equal in magnitude and opposite in direction to the system current, the way that the conductor 122 is connected in series with the battery 13 can simplify the structure and control scheme of the speaker assembly 1. When the speaker assembly 1 is working, the conductor 122 can obtain the counteracting current equal in magnitude and opposite in direction to the system current.

The above description only involves some embodiments of the present invention and is not intended to limit the present invention. The protection scope of the present invention is defined by the appended claims.

## Claims

1. A speaker assembly (1), comprising:
a battery (13) comprising a core (131), a positive electrode tab (132), and a negative electrode tab (133), the positive electrode tab (132) and the negative electrode tab (133) being electrically connected to the core (131) and being arranged on a first end face (1311) of the core (131);
an audio component (11) comprising a second end face (111) facing the first end face (1311); and
a magnetic field counteracting component (12) arranged on the second end face (111) and comprising a conductor (122),
so that a counteracting current into the conductor (122) forms a counteracting magnetic field acting on the audio component, and the counteracting magnetic field counteracts an interfering magnetic field acting by the battery (13) on the audio component, the speaker assembly being
**characterized in that**, the magnetic field counteracting component (12) further comprises an insulating layer (121) between the conductor (122) and the second end face (111);
the insulating layer (121) covers the second end face (111); and
the insulating layer (121) comprises an insulating adhesive layer bonded to the audio component (11), and is configured to avoid a functional interference of the conductor (122) with the audio component (11).

2. The speaker assembly (1) according to claim 1, wherein:
the conductor (122) comprises a first end (1221) and a second end (1222); and
in a thickness direction of the battery (13), the first end (1221) corresponds to a position of the positive electrode tab (132) and the second end (1222) corresponds to a position of the negative electrode tab (133).

3. The speaker assembly (1) according to claim 2, wherein the core (131) forms a main interference section (1312) between the positive electrode tab (132) and the negative electrode tab (133), and a projection of the conductor (122) in the thickness direction of the battery (13) coincides with the main interference section (1312).

4. The speaker assembly (1) according to claim 2 or 3, wherein:
an included angle between the positive electrode tab (132) and the negative electrode tab (133) includes 90°, and the conductor (122) comprises a 1/4 circular ring assembled on the insulating layer (121); or
an included angle between the positive electrode tab (132) and the negative electrode tab (133) is 180°, and the conductor (122) comprises a 1/2 circular ring assembled on the insulating layer (121).

5. The speaker assembly (1) according to any one of claims 1 to 4, wherein the conductor (122) is in an edge region of the second end face (111).

6. The speaker assembly (1) according to any one of claims 1 to 5, wherein the conductor (122) comprises a flexible circuit board or a wire assembled on the insulating layer (121).

7. The speaker assembly (1) according to any one of claims 1 to 6, wherein:
the battery (13) comprises a soft-packed battery, and the positive electrode tab (132) and the negative electrode tab (133) are exposed outside the core (131), or the battery (13) comprises a hard-packed battery, and the positive electrode tab (132) and the negative electrode tab (133) are arranged inside the core (131); and
in a thickness direction of the battery (13), at least a portion of the conductor (122) corresponds to positions of the positive electrode tab (132) and the negative electrode tab (133).

8. The speaker assembly (1) according to any one of claims 1 to 7, wherein the conductor (122) is connected in series with the battery (13), to obtain the counteracting current that is equal in magnitude and opposite in direction to a system current of the battery (13).

9. An earphone (2) comprising the speaker assembly (1) according to any one of claims 1-8.

10. A magnetic field counteracting method, applied to the speaker assembly (1) according to any one of claims 1-8, and comprising:
determining an assembly region of the conductor (122) based on positions of the positive electrode tab (132) and the negative electrode tab (133); and
arranging the magnetic field counteracting component (12) on the second end face (111), fixing the conductor (122) in the assembly region, and arranging the insulating layer (121) between the conductor (122) and the second end face (111),
**characterized in that**, the magnetic field counteracting method further comprises:
adjusting an intensity of the counteracting magnetic field based on an intensity of a magnetic field (30) of the battery (13) in a working state, wherein the working state at least comprises an audio playback state and a call state.

11. The magnetic field counteracting method according to claim 10, wherein determining the assembly region of the conductor (122) based on the positions of the positive electrode tab (132) and the negative electrode tab (133) comprises:
determining formation of a main interference section (1312) between the positive electrode tab (132) and the negative electrode tab (133) of the core (131); and
determining the assembly region based on a projection of the main interference section (1312) in a thickness direction of the battery (13).

12. The magnetic field counteracting method according to claim 10 or 11, wherein arranging the magnetic field counteracting component (12) on the second end face (111), fixing the conductor (122) in the assembly region, and arranging the insulating layer (121) between the conductor (122) and the second end face (111) comprises:
arranging the insulating layer (121) on the second end face (111); and
determining the assembly region on the insulating layer (121), and fixing the conductor (122) in the assembly region.

13. The magnetic field counteracting method according to any one of claims 10 to 12, further comprising:
electrically connecting a first end (1221) of the conductor (122) to the positive electrode tab (132), and electrically connecting a second end (1222) of the conductor (122) to the negative electrode tab (133).

## Patentansprüche

1. Eine Lautsprecheranordnung (1), die folgende Merkmale aufweist:
eine Batterie (13), die einen Kern (131), eine positive Elektrodenlasche (132) und eine negative Elektrodenlasche (133) aufweist, wobei die positive Elektrodenlasche (132) und die negative Elektrodenlasche (133) elektrisch mit dem Kern (131) verbunden sind und auf einer ersten Endfläche (1311) des Kerns (131) angeordnet sind;
eine Audiokomponente (11), die eine zweite Endfläche (111) aufweist, die der ersten Endfläche (1311) zugewandt ist; und
eine Magnetfeldentgegenwirkkomponente (12), die auf der zweiten Endfläche (111) angeordnet ist und einen Leiter (122) aufweist,
sodass ein entgegenwirkender Strom in den Leiter (122) ein entgegenwirkendes Magnetfeld bildet, das auf die Audiokomponente wirkt, und das entgegenwirkende Magnetfeld einem störenden Magnetfeld entgegenwirkt, das durch die Batterie (13) auf die Audiokomponente wirkt,
wobei die Lautsprecheranordnung **dadurch gekennzeichnet ist, dass** die Magnetfeldentgegenwirkkomponente (12) ferner eine Isolierschicht (121) zwischen dem Leiter (122) und der zweiten Endfläche (111) aufweist;
die Isolierschicht (121) die zweite Endfläche (111) bedeckt; und
die Isolierschicht (121) eine isolierende Haftschicht aufweist, die an die Audiokomponente (11) gebondet ist, und dazu konfiguriert ist, eine funktionelle Störung der Audiokomponente (11) durch den Leiter (122) zu vermeiden.

2. Die Lautsprecheranordnung (1) gemäß Anspruch 1, wobei:
der Leiter (122) ein erstes Ende (1221) und ein zweites Ende (1222) aufweist; und
in einer Dickenrichtung der Batterie (13) das erste Ende (1221) einer Position der positiven Elektrodenlasche (132) entspricht und das zweite Ende (1222) einer Position der negativen Elektrodenlasche (133) entspricht.

3. Die Lautsprecheranordnung (1) gemäß Anspruch 2, wobei der Kern (131) ein Hauptstörungssegment (1312) zwischen der positiven Elektrodenlasche (132) und der negativen Elektrodenlasche (133) bildet und ein Vorsprung des Leiters (122) in der Dickenrichtung der Batterie (13) mit dem Hauptstörungssegment (1312) zusammenfällt.

4. Die Lautsprecheranordnung (1) gemäß Anspruch 2 oder 3, wobei:
ein eingeschlossener Winkel zwischen der positiven Elektrodenlasche (132) und der negativen Elektrodenlasche (133) 90° umfasst und der Leiter (122) einen 1/4 kreisförmigen Ring aufweist, der auf der Isolierschicht (121) montiert ist; oder
ein eingeschlossener Winkel zwischen der positiven Elektrodenlasche (132) und der negativen Elektrodenlasche (133) 180° beträgt und der Leiter (122) einen 1/2 kreisförmigen Ring aufweist, der auf der Isolierschicht (121) montiert ist.

5. Die Lautsprecheranordnung (1) gemäß einem der Ansprüche 1 bis 4, wobei sich der Leiter (122) in einem Randbereich der zweiten Endfläche (111) befindet.

6. Die Lautsprecheranordnung (1) gemäß einem der Ansprüche 1 bis 5, wobei der Leiter (122) eine flexible Schaltungsplatine oder einen Draht aufweist, die/der auf der Isolierschicht (121) montiert ist.

7. Die Lautsprecheranordnung (1) gemäß einem der Ansprüche 1 bis 6, wobei:
die Batterie (13) eine weichgepackte Batterie aufweist und die positive Elektrodenlasche (132) und die negative Elektrodenlasche (133) außerhalb des Kerns (131) freiliegen oder die Batterie (13) eine hartgepackte Batterie aufweist und die positive Elektrodenlasche (132) und die negative Elektrodenlasche (133) innerhalb des Kerns (131) angeordnet sind; und
in einer Dickenrichtung der Batterie (13) zumindest ein Abschnitt des Leiters (122) Positionen der positiven Elektrodenlasche (132) und der negativen Elektrodenlasche (133) entspricht.

8. Die Lautsprecheranordnung (1) gemäß einem der Ansprüche 1 bis 7, wobei der Leiter (122) mit der Batterie (13) in Reihe geschaltet ist, um den entgegenwirkenden Strom zu erhalten, der in der Größe gleich und in der Richtung entgegengesetzt zu einem Systemstrom der Batterie (13) ist.

9. Ein Ohrhörer (2), der die Lautsprecheranordnung (1) gemäß einem der Ansprüche 1 bis 8 aufweist.

10. Ein Magnetfeldentgegenwirkverfahren, das auf die Lautsprecheranordnung (1) gemäß einem der Ansprüche 1 bis 8 angewendet wird und folgende Schritte aufweist:
Bestimmen eines Montagebereichs des Leiters (122) basierend auf Positionen der positiven Elektrodenlasche (132) und der negativen Elektrodenlasche (133); und
Anordnen der Magnetfeldentgegenwirkkomponente (12) auf der zweiten Endfläche (111), Fixieren des Leiters (122) in dem Montagebereich und Anordnen der Isolierschicht (121) zwischen dem Leiter (122) und der zweiten Endfläche (111),
**dadurch gekennzeichnet, dass** das Magnetfeldentgegenwirkverfahren ferner folgende Schritte aufweist:
Einstellen einer Intensität des entgegenwirkenden Magnetfelds basierend auf einer Intensität eines Magnetfelds (30) der Batterie (13) in einem Arbeitszustand, wobei der Arbeitszustand zumindest einen Audiowiedergabezustand und einen Anrufzustand aufweist.

11. Das Magnetfeldentgegenwirkverfahren gemäß Anspruch 10, wobei das Bestimmen des Montagebereichs des Leiters (122) basierend auf den Positionen der positiven Elektrodenlasche (132) und der negativen Elektrodenlasche (133) folgende Schritte aufweist:
Bestimmen der Bildung eines Hauptstörungssegments (1312) zwischen der positiven Elektrodenlasche (132) und der negativen Elektrodenlasche (133) des Kerns (131); und
Bestimmen des Montagebereichs basierend auf einem Vorsprung des Hauptstörungssegments (1312) in einer Dickenrichtung der Batterie (13).

12. Das Magnetfeldentgegenwirkverfahren gemäß Anspruch 10 oder 11, wobei das Anordnen der Magnetfeldentgegenwirkkomponente (12) auf der zweiten Endfläche (111), das Fixieren des Leiters (122) in dem Montagebereich und das Anordnen der Isolierschicht (121) zwischen dem Leiter (122) und der zweiten Endfläche (111) folgende Schritte aufweisen:
Anordnen der Isolierschicht (121) auf der zweiten Endfläche (111); und
Bestimmen des Montagebereichs auf der Isolierschicht (121) und Fixieren des Leiters (122) in dem Montagebereich.

13. Das Magnetfeldentgegenwirkverfahren gemäß einem der Ansprüche 10 bis 12, das ferner folgende Schritte aufweist:
elektrisches Verbinden eines ersten Endes (1221) des Leiters (122) mit der positiven Elektrodenlasche (132) und elektrisches Verbinden eines zweiten Endes (1222) des Leiters (122) mit der negativen Elektrodenlasche (133).

## Revendications

1. Ensemble haut-parleur (1), comprenant :
une batterie (13) comprenant un noyau (131), une languette de l'électrode positive (132) et une languette de l'électrode négative (133), la languette de l'électrode positive (132) et la languette de l'électrode négative (133) étant reliées électriquement au noyau (131) et étant disposées sur une première face d'extrémité (1311) du noyau (131) ;
un composant audio (11) comprenant une deuxième face d'extrémité (111) faisant face à la première face d'extrémité (1311) ; et
un composant de neutralisation de champ magnétique (12) disposé sur la deuxième face d'extrémité (111) et comprenant un conducteur (122),
de sorte qu'un courant de neutralisation circulant dans le conducteur (122) génère un champ magnétique de neutralisation agissant sur le composant audio, et le champ magnétique de neutralisation neutralise un champ magnétique interférant exercé par la batterie (13) sur le composant audio,
l'ensemble haut-parleur étant **caractérisé en ce que** le composant de neutralisation du champ magnétique (12) comprend en outre une couche isolante (121) entre le conducteur (122) et la deuxième face d'extrémité (111) ;
la couche isolante (121) recouvre la deuxième face d'extrémité (111) ; et
la couche isolante (121) comprend une couche adhésive isolante liée au composant audio (11) et est configurée pour éviter une interférence fonctionnelle du conducteur (122) avec le composant audio (11).

2. Ensemble haut-parleur (1) selon la revendication 1, dans lequel :
le conducteur (122) comprend une première extrémité (1221) et une deuxième extrémité (1222) ; et
dans un sens de l'épaisseur de la batterie (13), la première extrémité (1221) correspond à une position de la languette de l'électrode positive (132) et la deuxième extrémité (1222) correspond à une position de la languette de l'électrode négative (133).

3. Ensemble haut-parleur (1) selon la revendication 2, dans lequel le noyau (131) forme une section d'interférence principale (1312) entre la languette de l'électrode positive (132) et la languette de l'électrode négative (133), et une saillie du conducteur (122) dans le sens de l'épaisseur de la batterie (13) coïncide avec la section d'interférence principale (1312).

4. Ensemble haut-parleur (1) selon la revendication 2 ou 3, dans lequel :
un angle inclus entre la languette de l'électrode positive (132) et la languette de l'électrode négative (133) inclut 90°, et le conducteur (122) comprend un anneau circulaire de 1/4 monté sur la couche isolante (121) ; ou
un angle inclus entre la languette de l'électrode positive (132) et la languette de l'électrode négative (133) est de 180°, et le conducteur (122) comprend un anneau circulaire de 1/2 monté sur la couche isolante (121).

5. Ensemble haut-parleur (1) selon l'une quelconque des revendications 1 à 4, dans lequel le conducteur (122) est situé dans une zone périphérique de la deuxième face d'extrémité (111).

6. Ensemble haut-parleur (1) selon l'une quelconque des revendications 1 à 5, dans lequel le conducteur (122) comprend une carte de circuit imprimé flexible ou un fil monté sur la couche isolante (121).

7. Ensemble haut-parleur (1) selon l'une des quelconque des revendications 1 à 6, dans lequel :
la batterie (13) comprend une batterie à structure souple, et la languette de l'électrode positive (132) et la languette de l'électrode négative (133) sont exposées à l'extérieur du noyau (131), ou la batterie (13) comprend une batterie à structure rigide, et la languette de l'électrode positive (132) et la languette de l'électrode négative (133) sont disposées à l'intérieur du noyau (131) ; et
dans un sens de l'épaisseur de la batterie (13), au moins une partie du conducteur (122) correspond aux positions de la languette de l'électrode positive (132) et de la languette de l'électrode négative (133).

8. Ensemble haut-parleur (1) selon l'une quelconque des revendications 1 à 7, dans lequel le conducteur (122) est connecté en série à la batterie (13), pour obtenir le courant de neutralisation qui a une amplitude égale et un sens opposé à un courant de système de la batterie (13).

9. Écouteur (2) comprenant l'ensemble haut-parleur (1) selon l'une quelconque des revendications 1 à 8.

10. Procédé de neutralisation de champ magnétique, appliqué à l'ensemble haut-parleur (1) selon l'une quelconque des revendications 1 à 8, et comprenant :
la détermination d'une zone d'assemblage du conducteur (122) sur la base des positions de la languette de l'électrode positive (132) et de la languette de l'électrode négative (133) ; et
la disposition de l'élément de neutralisation du champ magnétique (12) sur la deuxième face d'extrémité (111), la fixation du conducteur (122) dans la zone d'assemblage, et la disposition de la couche isolante (121) entre le conducteur (122) et la deuxième face d'extrémité (111),
**caractérisé en ce que** le procédé de neutralisation du champ magnétique comprend en outre :
le réglage d'une intensité du champ magnétique de neutralisation sur la base d'une intensité d'un champ magnétique (30) de la batterie (13) dans un état de fonctionnement, dans lequel l'état de fonctionnement comprend au moins un état de lecture audio et un état d'appel.

11. Procédé de neutralisation de champ magnétique selon la revendication 10, dans lequel la détermination de la zone d'assemblage du conducteur (122) sur la base des positions de la languette de l'électrode positive (132) et de la languette de l'électrode négative (133) comprend :
la détermination de la formation d'une section d'interférence principale (1312) entre la languette de l'électrode positive (132) et la languette de l'électrode négative (133) du noyau (131) ; et
la détermination de la zone d'assemblage sur la base d'une projection de la section d'interférence principale (1312) dans un sens de l'épaisseur de la batterie (13).

12. Procédé de neutralisation du champ magnétique selon la revendication 10 ou 11, dans lequel la disposition de l'élément de neutralisation du champ magnétique (12) sur la deuxième face d'extrémité (111), la fixation du conducteur (122) dans la zone d'assemblage, et la disposition de la couche isolante (121) entre le conducteur (122) et la deuxième face d'extrémité (111), comprend :
la disposition de la couche isolante (121) sur la deuxième face d'extrémité (111) ; et
la détermination de la zone d'assemblage sur la couche isolante (121), et la fixation du conducteur (122) dans la zone d'assemblage.

13. Procédé de neutralisation du champ magnétique selon l'une quelconque des revendications 10 à 12, comprenant en outre :
la connexion électrique d'une première extrémité (1221) du conducteur (122) à la languette de l'électrode positive (132), et la connexion électrique d'une deuxième extrémité (1222) du conducteur (122) à la languette de l'électrode négative (133).
